(19) **Europäisches Patentamt / European Patent Office / Office européen des brevets**

(11) **EP 4 503 434 A1**

(12) **EUROPEAN PATENT APPLICATION**
published in accordance with Art. 153(4) EPC

(43) Date of publication:
**05.02.2025 Bulletin 2025/06**

(21) Application number: **23830020.6**

(22) Date of filing: **19.06.2023**

(51) International Patent Classification (IPC):
**H03H 7/01** $^{(2006.01)}$

(52) Cooperative Patent Classification (CPC):
**H03H 7/01; H03M 1/12; H04B 1/04; H04B 1/16**

(86) International application number:
**PCT/CN2023/101064**

(87) International publication number:
**WO 2024/001840 (04.01.2024 Gazette 2024/01)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 27.06.2022 CN 202210736778
07.09.2022 CN 202211091909

(71) Applicant: **Huawei Technologies Co., Ltd.**
**Shenzhen, Guangdong 518129 (CN)**

(72) Inventors:
• **YEO, Theng Tee**
  **Shenzhen, Guangdong 518129 (CN)**
• **CHEN, Sheng**
  **Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **DISCRETE TIME FILTER, RECEIVER, TRANSMITTER AND COMMUNICATION DEVICE**

(57) Embodiments of this application relate to the field of communication technologies, and provide a discrete-time filter, a receiver, a transmitter, and a communication device, to resolve a problem that extra power consumption and inconvenient adjustment are caused when a feedback coefficient of an existing discrete-time filter is adjusted. The discrete-time filter includes a transconductance circuit, a switched-capacitor filter circuit, a first sampling capacitor, a second sampling capacitor, and a switch, where an output end of the transconductance circuit is connected to a first node through the switched-capacitor filter circuit; both a first end of the first sampling capacitor and a first terminal of the switch are connected to the first node; and both a second terminal of the switch and a second end of the first sampling capacitor are grounded. The second sampling capacitor is connected to the switch, so that sampling is implemented and negative feedback is provided by switching connection ends of the switch, to adjust a feedback coefficient.

FIG. 5

EP 4 503 434 A1

## Description

This application claims priorities to Chinese Patent Application No. 202210736778.3, filed with the China National Intellectual Property Administration on June 27, 2022 and entitled "DISCRETE-TIME FILTER"; and to Chinese Patent Application No. 202211091909.3, filed with the China National Intellectual Property Administration on September 7, 2022 and entitled "DISCRETE-TIME FILTER, RECEIVER, TRANSMITTER, AND COMMUNICATION DEVICE", both of which are incorporated herein by reference in their entireties.

## TECHNICAL FIELD

This application relates to the field of communication technologies, and in particular, to a discrete-time filter, a receiver, a transmitter, and a communication device.

## BACKGROUND

In many communication systems, sensors, and measuring instruments, a high-performance filter is an indispensable module, and the high-performance filter directly affects and even determines quality of an in-band signal and a suppression degree of an out-of-band signal. A discrete-time filter is used more widely in a current communication system due to advantages such as high precision, low noise, low power consumption, and high scalability. However, the discrete-time filter has a disadvantage that a quality factor (referred to as a Q value for short below) is difficult to control, which greatly affects stability of an output signal of the filter. In order to control the Q value of the discrete-time filter, a feedback circuit is added in a current solution. However, when a feedback coefficient of the feedback circuit is adjusted, an additional circuit needs to be added. This introduces extra noise, and affects performance of the discrete-time filter while increasing costs.

## SUMMARY

Embodiments of this application provide a discrete-time filter, a receiver, a transmitter, and a communication device, to improve flexibility of feedback coefficient adjustment while ensuring performance of the discrete-time filter, and reduce costs.

To achieve the foregoing objectives, the following technical solutions are used in embodiments of this application.

According to a first aspect, a discrete-time filter is provided. The discrete-time filter includes a transconductance circuit, a switched-capacitor filter circuit, a first sampling capacitor, a second sampling capacitor, and a switch, where an output end of the transconductance circuit is connected to a first node through the switched-capacitor filter circuit, and both a first end of the first sampling capacitor and a first terminal of the switch are connected to the first node; and both a second terminal of the switch and a second end of the first sampling capacitor are grounded. The switch includes two odd-numbered ends and two even-numbered ends, where one odd-numbered end and one even-numbered end are connected to the first terminal of the switch, and the other odd-numbered end and the other even-numbered end are connected to the second terminal of the switch; and two ends of the second sampling capacitor are respectively connected to the two odd-numbered ends, or two ends of the second sampling capacitor are respectively connected to the two even-numbered ends. In this manner, when the two ends of the second sampling capacitor are respectively connected to the two odd-numbered ends of the switch, the discrete-time filter may sample an input signal through the first sampling capacitor and the second sampling capacitor. In this case, no feedback exists. In other words, a feedback coefficient is 0. When the two ends of the second sampling capacitor are respectively connected to the two even-numbered ends of the switch, polarities of two poles of the second sampling capacitor are reversed, and negative feedback is implemented during sampling. In this case, a feedback coefficient (denoted as β) is:

$$\beta = \frac{C_{sa} - C_{sb}}{C_{sa} + C_{sb}}$$

$C_{sa}$ represents a capacitance of the second sampling capacitor, and $C_{sb}$ represents a capacitance of the first sampling capacitor. On this basis, two types of adjustment on the feedback coefficient may be implemented.

In a possible implementation, at least one of the first sampling capacitor and the second sampling capacitor is an adjustable capacitor. On this basis, the feedback coefficient can be flexibly adjusted by adjusting a ratio of the first sampling capacitor to the second sampling capacitor. In an adjustment process, the capacitance of the second capacitor is always greater than the capacitance of the first capacitor.

In a possible implementation, the switched-capacitor filter circuit includes a first switch and a first capacitor; both a first end of the first switch and a first end of the first capacitor are connected to the output end of the transconductance circuit; a second end of the first switch is connected to the first node; and a second end of the first capacitor is grounded. When the discrete-time filter runs, the two ends of the second sampling capacitor are first respectively connected to the two odd-numbered ends of the switch, and the first sampling capacitor and the second sampling capacitor sample the input signal. At the same time, the first switch is turned on, and the first capacitor filters the input signal. After a period of time, the two ends of the second sampling capacitor are respectively connected to the two even-numbered ends of the switch, to convert the polarities of the two poles of the second sampling capacitor, and the negative feedback is implemented by using the second sampling capacitor, to adjust the feedback coefficient. On this basis, a feedback coefficient of the first-order discrete-time filter can be adjusted.

In a possible implementation, the switched-capacitor filter circuit further includes a second switch and a second capacitor. A first end of the second switch is connected to the first node; a second end of the second switch is connected to a first end of the second capacitor; and a second end of the second capacitor is grounded. When the discrete-time filter runs, the two ends of the second sampling capacitor are first respectively connected to the two odd-numbered ends of the switch, and the input signal is sampled via the first sampling capacitor and the second sampling capacitor. At the same time, the first switch is continuously turned on for a period of time, and the first capacitor is used for filtering the input signal. Then, the first switch is turned off, the second switch is continuously turned on for a period of time, and the second capacitor is used for further filtering the input signal continuously. Then, the two ends of the second sampling capacitor are respectively connected to the two even-numbered ends of the switch, to convert the polarities of the two poles of the second sampling capacitor, and the second switch is turned off. Then, the first switch and the second switch are turned on in the same sequence above, and the negative feedback is implemented by using the second sampling capacitor, to adjust the feedback coefficient. On this basis, a feedback coefficient of the second-order discrete-time filter can be adjusted.

In a possible implementation, the switched-capacitor filter circuit further includes a third switch and a third capacitor A first end of the third switch is connected to the first node; a second end of the third switch is connected to a first end of the third capacitor; and a second end of the third capacitor is grounded. When the discrete-time filter runs, the two ends of the second sampling capacitor are first respectively connected to the two odd-numbered ends of the switch, and the input signal is sampled via the first sampling capacitor and the second sampling capacitor. At the same time, the first switch is continuously turned on for a period of time, and the first capacitor is used for filtering the input signal. Then, the first switch is turned off, the second switch is turned on, and the second capacitor is used for further filtering the input signal. Then, the second switch is turned off, the third switch is continuously turned on for a period of time, and the third capacitor is used for further filtering the input signal. Then, the two ends of the second sampling capacitor are respectively connected to the two even-numbered ends of the switch, to convert the polarities of the two poles of the second sampling capacitor, and the third switch is turned off. Then, the first switch, the second switch, and the third switch are turned on in the same sequence above, and the negative feedback is implemented by using the second sampling capacitor, to adjust the feedback coefficient. On this basis, a feedback coefficient of the third-order discrete-time filter can be adjusted.

It may be understood that quantities of switches and capacitors in the switched-capacitor filter circuit may be correspondingly adjusted based on an order of the discrete-time filter. For example, when the discrete-time filter is a fourth-order discrete-time filter, the switched-capacitor filter circuit may further include a fourth switch and a fourth capacitor, where a first end of the fourth switch is connected to the first node, a second end of the fourth switch is connected to a first end of the fourth capacitor, and a second end of the fourth capacitor is grounded.

According to a second aspect, a discrete-time filter is provided. The discrete-time filter includes a differential transconductance circuit, a first switched-capacitor filter circuit, a second switched-capacitor filter circuit, a first sampling capacitor, a second sampling capacitor, a third sampling capacitor, and a switch. A first output end of the differential transconductance circuit is connected to a first node through the first switched-capacitor filter circuit; both a first end of the first sampling capacitor and a first terminal of the switch are connected to the first node; a second output end of the differential transconductance circuit is connected to a second node through the second switched-capacitor filter circuit; both a first end of the second sampling capacitor and a second terminal of the switch are connected to the second node; and both a second end of the first sampling capacitor and a second end of the second sampling capacitor are grounded. In addition, the switch includes two odd-numbered ends and two even-numbered ends, where one odd-numbered end and one even-numbered end are connected to the first terminal of the switch, and the other odd-numbered end and the other even-numbered end are connected to the second terminal of the switch; and two ends of the second sampling capacitor are respectively connected to the two odd-numbered ends, or two ends of the second sampling capacitor are respectively connected to the two even-numbered ends. In this manner, when the two ends of the second sampling capacitor are respectively connected to the two odd-numbered ends of the switch, the discrete-time filter may sample a differential input signal through the first sampling capacitor, the second sampling capacitor, and the third sampling capacitor. In this case, no feedback exists. In other words, a feedback coefficient is 0. When the two ends of the second sampling capacitor are respectively connected to the two even-numbered ends of the switch, polarities of two poles of the second sampling capacitor are reversed, and negative feedback is implemented during sampling. In this case, a feedback coefficient exists.

In a possible implementation, at least one of the first sampling capacitor, the second sampling capacitor, and the third sampling capacitor is an adjustable capacitor. On this basis, the feedback coefficient may be adjusted by adjusting a ratio of the foregoing three capacitors.

In a possible implementation, the first switched-capacitor filter circuit and the second switched-capacitor filter circuit each include a first switch and a first capacitor. Both a first end of the first switch and a first end of the first capacitor in the first switched-capacitor filter circuit are connected to the first output end of the differential transconductance circuit; a second end of the first switch in the first switched-capacitor filter circuit is connected to the first node; a second end of the first capacitor in the first switched-capacitor filter circuit is grounded; both a first end of the first switch and a first end of the first capacitor in the second switched-capacitor filter circuit are connected to the second output end of the differential transconductance circuit; a second end of the first switch in the second switched-capacitor filter circuit is connected to the second node; and a second end of the first capacitor in the second switched-capacitor filter circuit is grounded.

In a possible implementation, the first switched-capacitor filter circuit and the second switched-capacitor filter circuit each include a second switch and a second capacitor. A first end of the second switch in the first switched-capacitor filter circuit is connected to the first node; a second end of the second switch in the first switched-capacitor filter circuit is connected to a first end of the second capacitor in the first switched-capacitor filter circuit; a first end of the second switch in the second switched-capacitor filter circuit is connected to the second node; a second end of the second switch in the second switched-capacitor filter circuit is connected to a first end of the second capacitor in the second switched-capacitor filter circuit; and both a second end of the second capacitor in the first switched-capacitor filter circuit and a second end of the second capacitor in the second switched-capacitor filter circuit are grounded.

In a possible implementation, the first switched-capacitor filter circuit and the second switched-capacitor filter circuit each include a third switch and a third capacitor. A first end of the third switch in the first switched-capacitor filter circuit is connected to the first node; a second end of the third switch in the first switched-capacitor filter circuit is connected to a first end of the third capacitor in the first switched-capacitor filter circuit; a first end of the third switch in the second switched-capacitor filter circuit is connected to the second node; a second end of the third switch in the second switched-capacitor filter circuit is connected to a first end of the third capacitor in the second switched-capacitor filter circuit; and both a second end of the third capacitor in the first switched-capacitor filter circuit and a second end of the third capacitor in the second switched-capacitor filter circuit are grounded.

According to a third aspect, a receiver is provided. The receiver includes a mixer, a filter, and an analog-to-digital converter that are sequentially connected, where the filter includes the discrete-time filter in any one of the possible implementations of the first aspect and the second aspect.

According to a fourth aspect, a transmitter is provided. The transmitter includes a digital-to-analog converter, a filter, and a mixer that are sequentially connected, where the filter includes the discrete-time filter in any one of the possible implementations of the first aspect and the second aspect.

According to a fifth aspect, a communication device is provided. The communication device includes the receiver in the third aspect and a receive antenna connected to the receiver, and/or the transmitter in the fourth aspect and a transmit antenna connected to the transmitter.

For technical effects brought by the second aspect to the fifth aspect and the possible implementations, refer to the descriptions of the technical effects brought by the first aspect and the possible implementations. Details are not described herein again.

**BRIEF DESCRIPTION OF DRAWINGS**

FIG. 1a is a diagram of a structure of a receiver;
FIG. 1b is a diagram of a structure of a transmitter;
FIG. 2a is a diagram of a passive discrete-time filter;
FIG. 2b is a control time sequence diagram of the passive discrete-time filter in FIG. 2a;
FIG. 3 is a diagram of another passive discrete-time filter;
FIG. 4a is a diagram of another passive discrete-time filter;
FIG. 4b is a control time sequence diagram of the passive discrete-time filter in FIG. 4a;
FIG. 5 is an equivalent circuit diagram of a discrete-time filter according to an embodiment of this application;
FIG. 6 is a control time sequence diagram of the discrete-time filter in FIG. 5;
FIG. 7 is a block diagram of an equivalent system corresponding to the discrete-time filter in FIG. 5;
FIG. 8 is an equivalent circuit diagram of another discrete-time filter according to an embodiment of this application;
FIG. 9 is a control time sequence diagram of the discrete-time filter in FIG. 8;
FIG. 10 is a block diagram of an equivalent system corresponding to the discrete-time filter in FIG. 8;
FIG. 11 is an equivalent circuit diagram of another discrete-time filter according to an embodiment of this application;
FIG. 12 is a control time sequence diagram of the discrete-time filter in FIG. 11;
FIG. 13 is a block diagram of an equivalent system corresponding to the discrete-time filter in FIG. 11;
FIG. 14 is an equivalent circuit diagram of a discrete-time filter according to an embodiment of this application;

FIG. 15 is a control time sequence diagram of the discrete-time filter in FIG. 14;

FIG. 16 is a diagram of a frequency response of the discrete-time filter in FIG. 14 under different feedback coefficients;

FIG. 17 is a block diagram of an equivalent system corresponding to the discrete-time filter in FIG. 14;

FIG. 18 is a diagram of a fully-differential discrete-time filter according to an embodiment of this application;

FIG. 19 is a diagram of another fully-differential discrete-time filter according to an embodiment of this application; and

FIG. 20 is a diagram of another fully-differential discrete-time filter according to an embodiment of this application.

## DESCRIPTION OF EMBODIMENTS

The following describes the technical solutions in embodiments of this application with reference to the accompanying drawings in embodiments of this application.

In the descriptions of this application, unless otherwise specified, "/" indicates that associated objects are in an "or" relationship. For example, A/B may represent A or B. The term "and/or" in this application merely describes an association relationship between associated objects and indicates that three relationships may exist. For example, A and/or B may represent three cases: Only A exists, both A and B exist, or only B exists, where A and B may be singular or plural. In addition, in the descriptions of this application, "a plurality of" means two or more than two unless otherwise specified. "At least one item (piece) of the following" or a similar expression thereof means any combination of these items, including a singular item (piece) or any combination of plural items (pieces). For example, at least one of a, b, or c may indicate: a; b; c; a and b; a and c; b and c; or a, b, and c; where a, b, and c may be singular or plural. In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, terms such as "example" or "for example" are used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

The following describes this application in detail with reference to the accompanying drawings and embodiments.

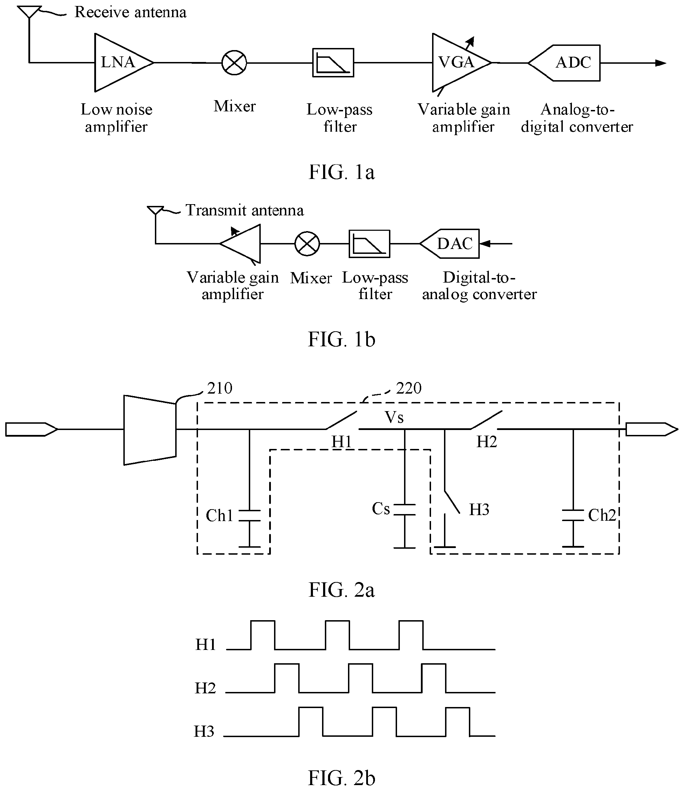

Currently, in circuits of many sensors and measuring instruments, a high-performance filter is indispensable. In addition, the filter is widely used in a wired communication system and a wireless communication system, and the high-performance filter is also an indispensable important module in the communication system. The high-performance filter directly affects or even determines quality of an in-band signal and a suppression degree of an out-of-band signal in the communication system. A communication device in the communication system usually includes a transmitter and a receiver. The receiver usually includes a plurality of receive links, and the transmitter usually includes a plurality of receive links. As shown in FIG. 1 a, each receive link in a receiver includes a receive antenna, a low noise amplifier (low noise amplifier, LNA), a mixer (mixer, MIX), a low-pass filter (low-pass filter, LPF), a variable gain amplifier (variable gain amplifier, VGA), a digital-to-analog converter (analog-to-digital converter, ADC), and the like that are sequentially connected. An input signal received by the receive antenna is amplified by the LNA and then converted into an intermediate frequency signal by the MIX. The intermediate frequency signal is filtered by the LPF and then amplified by the VGA again. Finally, the ADC converts an amplified intermediate frequency signal into a digital signal and outputs the digital signal. As shown in FIG. 1b, each transmit link in a transmitter includes a digital-to-analog converter, a low-pass filter, a mixer, a variable gain amplifier, a transmit antenna, and the like that are sequentially connected. After the digital-to-analog converter converts a received digital signal into an analog signal, the low-pass filter filters the signal. A filtered signal is mixed by the mixer and then amplified by the variable gain amplifier. Finally, a signal is transmitted to a receiver through the transmit antenna. In the transmitter and the receiver, discrete-time filters are usually used as the low-pass filters.

Discrete-time filters are classified into an active discrete-time filter and a passive discrete-time filter. The passive discrete-time filter is widely used due to features such as a simple structure, low costs, and high reliability. As shown in FIG. 2a, an existing passive discrete-time filter usually includes a transconductance circuit 210, a switched-capacitor filter circuit 220, a sampling capacitor Cs, and the like, where a capacitor Ch1 and a switch H1 form a first switched-capacitor filter circuit, and a capacitor Ch2, a switch H2, and a switch H3 form a second switched-capacitor filter circuit; and the sampling capacitor Cs is located between the two switched-capacitor filter circuits. A running time sequence of the passive discrete-time filter is shown in FIG. 2b. First, the switch H1 is closed, the sampling capacitor Cs samples an input signal, and the capacitor Ch1 filters the input signal; then, the switch H1 is open, the switch H2 is closed, the sampling capacitor Cs outputs a sampling signal, and the capacitor Ch2 filters the sampling signal; and finally, the switch H2 is open, the switch H3 is closed, and the circuits are reset. A disadvantage of the passive discrete-time filter is that there is no feedback, and because all circuits in the passive discrete-time filter are cascaded with real poles, a Q value of the passive discrete-time filter is very low. As an order of the passive discrete-time filter gradually increases, attenuation of an in-band signal becomes increasingly severe.

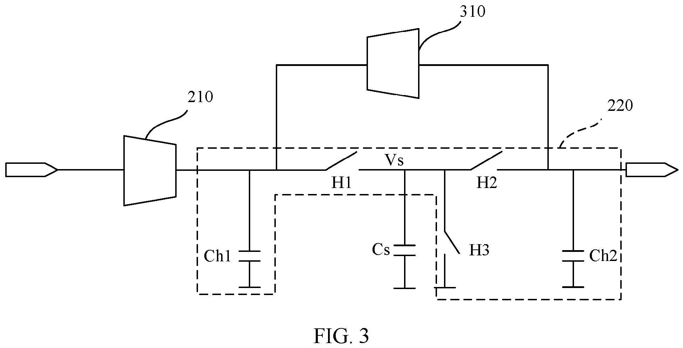

To resolve this problem, as shown in FIG. 3, in some solutions, an active transconductance circuit 310 is added on the basis of FIG. 2a; an input end of the active transconductance circuit 310 is connected to an output end output of the passive discrete-time filter; and an output end of the active transconductance circuit 310 is connected to an output end of the transconductance circuit 210. A control time sequence of the discrete-time filter is the same as that in FIG. 2b, and details are not described herein again. Although the active transconductance circuit 310 may provide a negative feedback signal when a signal is output, setting the additional active transconductance circuit not only increases overall power consumption of an entire circuit and introduce extra noise, but also increases an overall area of the entire circuit. In addition, because an amplitude of the output signal is usually large, an amplitude of an input signal of the active transconductance circuit is also large. This deteriorates linearity of the entire circuit to a great extent.

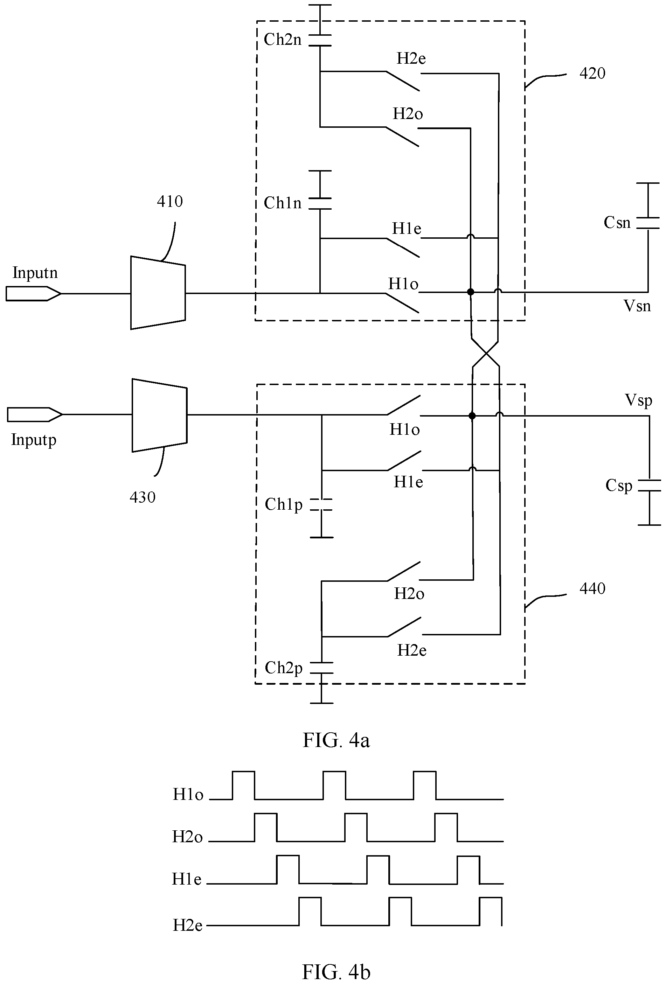

Currently, a passive discrete-time filter also uses a fully-differential circuit structure. As shown in FIG. 4a, a passive discrete-time filter includes two differential input ports (Inputp and Inputn), a first transconductance circuit 410 connected to the differential input port Inputn, a first switched-capacitor filter circuit 420 connected to the first transconductance circuit 410, a sampling capacitor Csn and a first output port Vsn connected to the first switched-capacitor filter circuit 420, a second transconductance circuit 430 connected to the differential input port Inputp, a second switched-capacitor filter circuit 440 connected to the second transconductance circuit 430, and a sampling capacitor Csp and a second output port Vsp connected to the second switched-capacitor filter circuit 440. The first switched-capacitor filter circuit 420 and the second switched-capacitor filter circuit 440 each include a capacitor Chin, a capacitor Ch2n, a switch H1o, a switch H2o, a switch H1e, and a switch H2e. A first end of the capacitor Chin, a first end of the switch H1o, and a first end of the switch H1e in the first switched-capacitor filter circuit 420 are all connected to an output end of the first transconductance circuit 410; a second end of the capacitor Chin in the first switched-capacitor filter circuit 420 is grounded; a second end of the switch H1o in the first switched-capacitor filter circuit 420 is connected to a first end of the sampling capacitor Csn and the first output port Vsn; and a second end of the switch H1e in the first switched-capacitor filter circuit 420 is connected to a first end of the sampling capacitor Csp and the second output port Vsp. A first end of the capacitor Ch2n in the second switched-capacitor filter circuit 440 is connected to a second end of the switch H1o through the switch H2o; and a first end of the capacitor Ch2n in the switched-capacitor filter circuit 420 is connected to the second end of the switch H1o in the second switched-capacitor filter circuit 440 through the switch H2e. A first end of the capacitor Chin, a first end of the switch H1o, and a first end of the switch H1e in the second switched-capacitor filter circuit 440 are all connected to an output end of the second transconductance circuit 430; a second end of the capacitor Ch1n in the second switched-capacitor filter circuit 440 is grounded; the second end of the switch H1o in the second switched-capacitor filter circuit 440 is connected to the first end of the sampling capacitor Csn and the first output port Vsn; and a second end of the switch H1e in the second switched-capacitor filter circuit 440 is connected to the first end of the sampling capacitor Csp and the second output port Vsp. The first end of the capacitor Ch2n in the second switched-capacitor filter circuit 440 is connected to the second end of the switch H1o through the switch H2o; and the first end of the capacitor Ch2n in the second switched-capacitor filter circuit 440 is connected to the second end of the switch H1o in the first switched-capacitor filter circuit 420 through the switch H2e.

A control time sequence of the passive discrete-time filter is shown in FIG. 4b. A control time sequence of the switch H1o, the switch H2o, the switch H1e, and the switch H2e in the first switched-capacitor filter circuit 420 is the same as that in the second switched-capacitor filter circuit 440. Specifically, when the passive discrete-time filter runs, the switch H1o is first turned on, the sampling capacitor Csn and the sampling capacitor Csp are used for sampling differential input signals respectively, and filtering is performed by the capacitor Ch1n and the capacitor Chip separately. Next, the switch H1o is turned off, the switch H2o is turned on, and filtering is performed by the capacitor Ch2n and the capacitor Ch2p separately. Then, the switch H2o is turned off, the switch H1e is turned on, and feedback is performed once. Finally, the switch H1e is turned off, the switch H2e is turned on, and feedback is performed again. However, a feedback coefficient in this solution can only be 1 and cannot be adjusted. An excessively high Q value is caused when the feedback coefficient is equal to 1, and both an amplitude response and a phase response of the filter are affected.

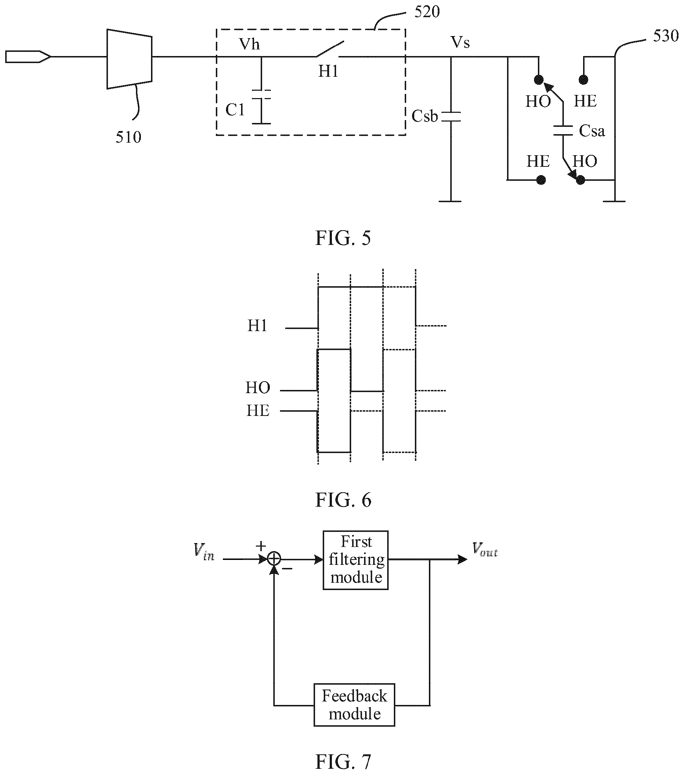

To resolve the foregoing problems, as shown in FIG. 5, an embodiment of this application provides a discrete-time filter. The discrete-time filter includes a transconductance circuit 510, a switched-capacitor filter circuit 520, a first sampling capacitor Csb, a second sampling capacitor Csa, and a switch 530, where an output end of the transconductance circuit 510 is connected to a first node Vs through the switched-capacitor filter circuit 520; both a first end of the first sampling capacitor Csb and a first terminal of the switch 530 are connected to the first node; and both a second terminal of the switch 530 and a second end of the first sampling capacitor Csb are grounded. The switch 530 includes two odd-numbered ends (HOs) and two even-numbered ends (HEs), where one odd-numbered end and one even-numbered end are connected to the first terminal of the switch 530, and the other odd-numbered end and the other even-numbered end are connected to the second terminal of the switch 530; and two ends of the second sampling capacitor Csa are respectively connected to the two odd-numbered ends, or two ends of the second sampling capacitor Csa are respectively connected to the two even-numbered ends.

In the foregoing manner, the second sampling capacitor Csa can adjust polarities. When the second sampling capacitor Csa is connected to the two odd-numbered ends of the switch 530, the first sampling capacitor Csb and the second sampling capacitor Csa may sample an input signal. In this case, there is no feedback. In other words, a feedback coefficient is 0. When the second sampling capacitor Csa is connected to the two even-numbered ends of the switch 530, polarities of the two poles of the second sampling capacitor Csa are exchanged, and negative feedback may be provided. In this case, a calculation manner of the feedback coefficient $\beta$ is as follows:

$$\beta = \frac{C_{sa} - C_{sb}}{C_{sa} + C_{sb}}$$

$C_{sa}$ represents a capacitance of the second sampling capacitor Csa, and $C_{sb}$ represents a capacitance of the first sampling capacitor Csb. On this basis, two types of adjustment on the feedback coefficient may be implemented.

In an implementation solution, to adjust the feedback coefficient more flexibly, at least one of the first sampling capacitor Csb and the second sampling capacitor Csa may be an adjustable capacitor. The feedback coefficient can be adjusted by adjusting a ratio of the first sampling capacitor Csb to the second sampling capacitor Csa. It may be understood that, in an adjustment process, the capacitance of the second sampling capacitor Csa cannot be less than the capacitance of the first sampling capacitor Csb.

In an implementation solution, still as shown in FIG. 5, the switched-capacitor filter circuit 520 may include a first switch H1 and a first capacitor C1. Both a first end of the first switch H1 and a first end of the first capacitor C1 are connected to the output end of the transconductance circuit; a second end of the first switch H1 is connected to the first node; and a second end of the first capacitor C1 is grounded. A first-order filter circuit may be formed by using the first switch H1 and the first capacitor C1.

When the discrete-time filter runs, a control time sequence of the discrete-time filter is shown in FIG. 6, where the first switch H1 and the switch 530 are controlled through an externally input clock signal. First, a high level may be input to the switch 530, the two ends of the second sampling capacitor Csa are controlled to be respectively connected to the two odd-numbered ends of the switch 530, and a high level is input to the first switch H1, to control the first switch H1 to be turned on. In this case, the first sampling capacitor Csb and the second sampling capacitor Csa may be used for sampling the input signal, and the first capacitor C1 is used for filtering the input signal. After a period of time, the high level of the switch 530 may be switched to a low level, and the two ends of the second sampling capacitor Csa are controlled to be respectively connected to the two even-numbered ends of the switch 530, to convert the polarities of the two poles of the second sampling capacitor Csa. Because the previous sampling signal still exists in the second sampling capacitor Csa, the second sampling capacitor Csa may be used for implementing the negative feedback, to adjust the feedback coefficient. On this basis, a feedback coefficient of the first-order discrete-time filter can be adjusted.

It may be understood that the foregoing discrete-time filter may also be equivalent to a structure shown in FIG. 7. A digital filter formed by a disposed subtractor, filtering module, feedback module, and the like filters an input signal. Specifically, the input signal is sent to the filtering module through the subtractor, the filtering module filters an output signal to obtain an output signal, and the output signal is fed back to the subtractor through the feedback module. A function of the filtering module is:

$$H(z) = \frac{\overline{\alpha_1} z^{-1}}{1 - \alpha_1 z^{-1}}$$

The parameters $\alpha_1$ and $\overline{\alpha_1}$ are calculated as follows:

$$\alpha_1 = \frac{C1}{C1 + C_{sa} + C_{sb}}$$

$$\overline{\alpha_1} = 1 - \alpha_1$$

A calculation manner of the feedback module is as follows:

$$\beta = \frac{C_{sa} - C_{sb}}{C_{sa} + C_{sb}}$$

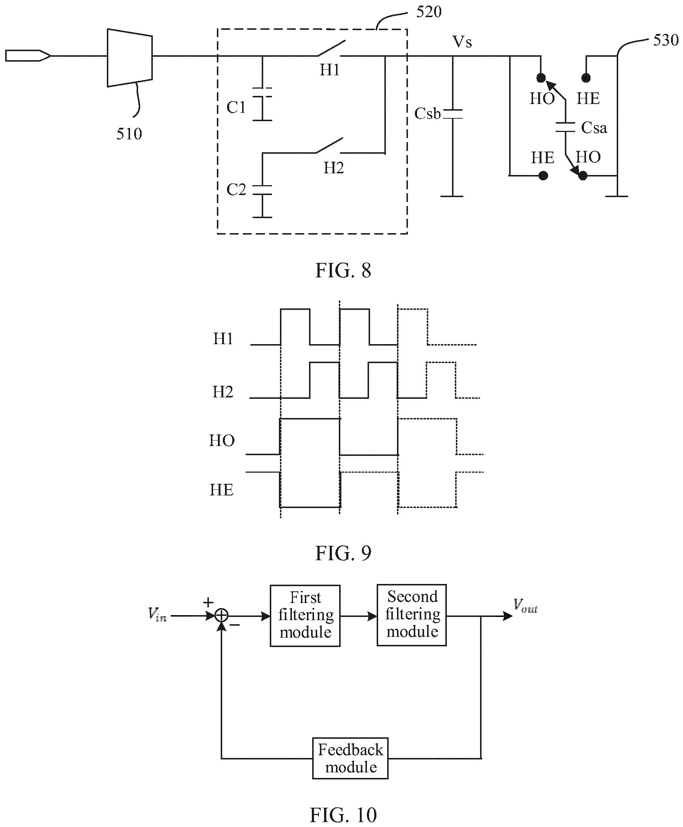

In an implementation solution, as shown in FIG. 8, the switched-capacitor filter circuit 520 may further include a second switch H2 and a second capacitor C2. A first end of the second switch H2 is connected to the first node; a second end of the second switch H2 is connected to a first end of the second capacitor C2; and a second end of the second capacitor C2 is grounded. Capacitances of the first capacitor C1 and the second capacitor C2 are different, and a second-order filter circuit may be formed by using the first switch H1, the first capacitor C1, the second switch H2, and the second capacitor C2.

When a discrete-time filter runs, a control time sequence of the discrete-time filter is shown in FIG. 9, where the first switch H1, the second switch H2, and the switch 530 are controlled through an externally input clock signal. First, a high level may be input to the switch 530, the two ends of the second sampling capacitor Csa are controlled to be respectively connected to the two odd-numbered ends of the switch 530, and a high level is input to the first switch H1 for a period of time, to control the first switch H1 to be turned on. In this case, the first sampling capacitor Csb and the second sampling capacitor Csa may be used for sampling the input signal, and the first capacitor C1 is used for filtering the input signal. After a period of time, a low level is input to the first switch H1, and the first switch H1 is turned off; and a high level is input to the second switch H2, the second switch H2 is controlled to be turned on, and the second capacitor C2 is used for filtering again. After a period of time, a low level may be input to the second switch H2, and the second switch H2 is turned off; and a high level is input to the first switch H1, a low level is input to the switch 530, and the two ends of the second sampling capacitor Csa are controlled to be respectively connected to the two even-numbered ends of the switch 530, to convert the polarities of the two poles of the second sampling capacitor Csa, and perform filtering by using the first capacitor C1. Then, a low level is input to the first switch H1, and the first switch H1 is turned off; and a high level is input to the second switch H2, the second switch H2 is controlled to be turned on, and the second capacitor C2 is used for filtering again. The negative feedback is implemented by changing the polarities of the second sampling capacitor Csa, to adjust a feedback coefficient of the second-order discrete-time filter.

It may be understood that the foregoing discrete-time filter may also be equivalent to a structure shown in FIG. 10. A digital filter formed by a disposed subtractor, first filtering module, second filtering module, feedback module, and the like filters an input signal. Specifically, the input signal is sent to the first filtering module through the subtractor; the first filtering module filters an output signal and then sends a filtered signal to the second filtering module; and the second filtering module filters the received signal to obtain an output signal. In addition, the output signal is also fed back to the subtractor through the feedback module. A function of the first filtering module is:

$$H(z) = \frac{\overline{\alpha_1}z^{-1}}{1 - \alpha_1 z^{-1}}$$

The parameters $\alpha_1$ and $\overline{\alpha_1}$ are calculated as follows:

$$\alpha_1 = \frac{C1}{C1 + C_{sa} + C_{sb}}$$

$$\overline{\alpha_1} = 1 - \alpha_1$$

A function of the second filtering module is:

$$H(z) = \frac{\overline{\alpha_2}z^{-1}}{1 - \alpha_2 z^{-1}}$$

The parameters $\alpha_2$ and $\overline{\alpha_2}$ are calculated as follows:

$$\alpha_2 = \frac{C2}{C2 + C_{sa} + C_{sb}}$$

$$\overline{\alpha_2} = 1 - \alpha_2$$

A calculation manner of the feedback module is as follows:

$$\beta = \frac{C_{sa} - C_{sb}}{C_{sa} + C_{sb}}$$

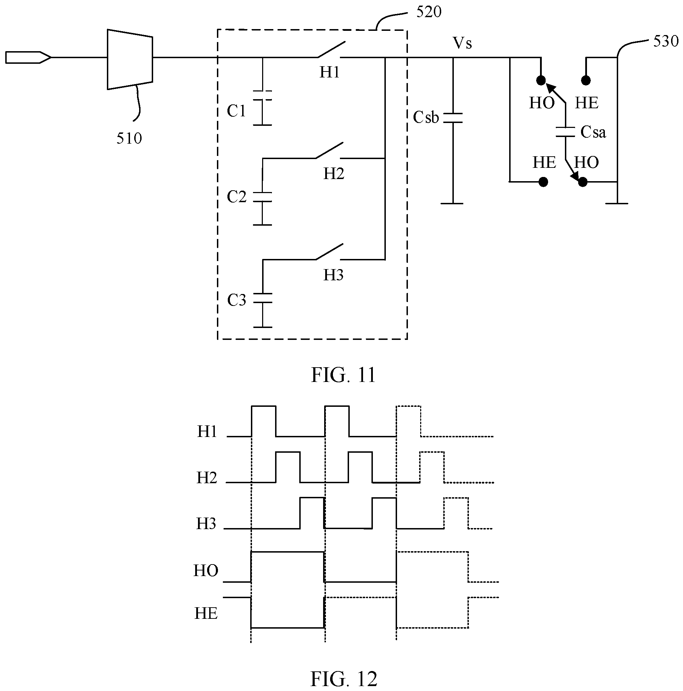

In an implementation solution, as shown in FIG. 11, the switched-capacitor filter circuit 520 may further include a third switch H3 and a third capacitor C3. A first end of the third switch H3 is connected to the first node; a second end of the third switch H3 is connected to a first end of the third capacitor C3; and a second end of the third capacitor C3 is grounded. Capacitances of the first capacitor C1, the second capacitor C2, and the third capacitor C3 are all different, and a third-order filter circuit may be formed by using the first switch H1, the first capacitor C1, the second switch H2, the second capacitor C2, the third switch H3, and the third capacitor C3.

For example, when the discrete-time filter runs, a control time sequence of the discrete-time filter is shown in FIG. 12, where the first switch H1, the second switch H2, the third switch H3, and the switch 530 are controlled through an externally input clock signal. First, a high level may be input to the switch 530, the two ends of the second sampling capacitor Csa are controlled to be respectively connected to the two odd-numbered ends of the switch 530, and a high level is input to the first switch H1 for a period of time, to control the first switch H1 to be turned on. In this case, the first sampling capacitor Csb and the second sampling capacitor Csa may be used for sampling the input signal, and the first capacitor C1 is used for filtering the input signal. After a period of time, a low level is input to the first switch H1, and the first switch H1 is turned off; and a high level is input to the second switch H2, the second switch H2 is controlled to be turned on, and the second capacitor C2 is used for filtering again. After a period of time again, a low level is input to the second switch H2, and the second switch H2 is turned off; and a high level is input to the third switch H3, the third switch H3 is controlled to be turned on, and the third capacitor C3 is used for filtering again. After a period of time again, a low level is input to the third switch H3 and the third switch H3 is turned off; a low level is input to the switch 530, and the two ends of the second sampling capacitor Csa are controlled to be respectively connected to the two even-numbered ends of the switch 530, to convert the polarities of the two poles of the second sampling capacitor Csa; and a high level is input to the first switch H1 and the first capacitor C1 is used for filtering. After a period of time, a low level is input to the first switch H1, and the first switch H1 is turned off; and a high level is input to the second switch H2, the second switch H2 is controlled to be turned on, and the second capacitor C2 is used for filtering again. After a period of time again, a low level is input to the second switch H2, and the second switch H2 is turned off; and a high level is input to the third switch H3, the third switch H3 is controlled to be turned on, and the third capacitor C3 is used for filtering again. On this basis, a feedback coefficient of the third-order discrete-time filter may be adjusted by changing the polarities of the second sampling capacitor Csa.

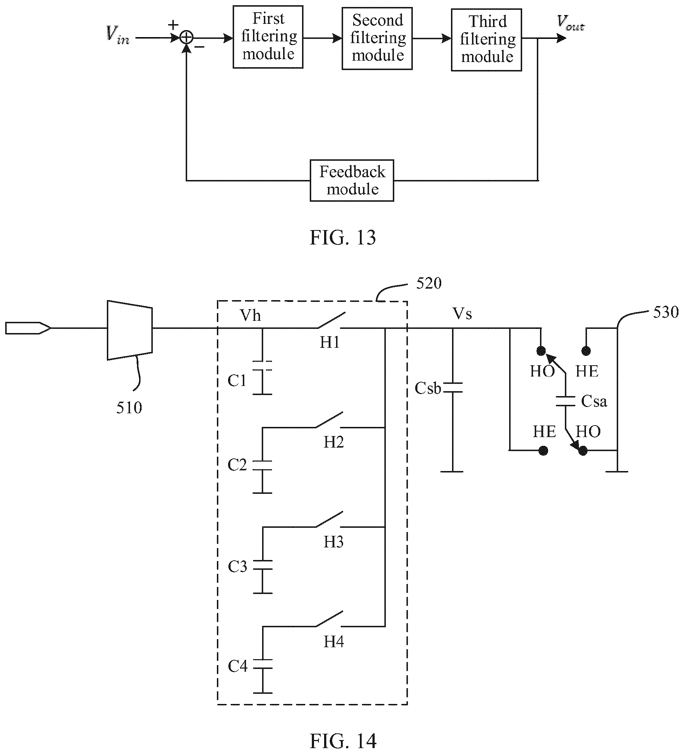

It may be understood that the foregoing discrete-time filter may also be equivalent to a structure shown in FIG. 13. A digital filter formed by a disposed subtractor, first filtering module, second filtering module, third filtering module, feedback module, and the like filters an input signal. Specifically, the input signal is sent to the first filtering module through the subtractor; the first filtering module filters an output signal and then sends a filtered signal to the second filtering module; the second filtering module filters the received signal and then sends a filtered signal to the third filtering module; and the third filtering module filters the received signal to obtain an output signal. In addition, the output signal is also fed back to the subtractor through the feedback module. A function of the first filtering module is:

$$H(z) = \frac{\overline{\alpha_1} z^{-1}}{1 - \alpha_1 z^{-1}}$$

The parameters $\alpha_1$ and $\overline{\alpha_1}$ are calculated as follows:

$$\alpha_1 = \frac{C1}{C1 + C_{sa} + C_{sb}}$$

$$\overline{\alpha_1} = 1 - \alpha_1$$

A function of the second filtering module is:

$$H(z) = \frac{\overline{\alpha_2} z^{-1}}{1 - \alpha_2 z^{-1}}$$

The parameters $\alpha_2$ and $\overline{\alpha_2}$ are calculated as follows:

$$\alpha_2 = \frac{C2}{C2 + C_{sa} + C_{sb}}$$

$$\overline{\alpha_2} = 1 - \alpha_2$$

A function of the third filtering module is:

$$H(z) = \frac{\overline{\alpha_3} z^{-1}}{1 - \alpha_3 z^{-1}}$$

The parameters $\alpha_3$ and $\overline{\alpha_3}$ are calculated as follows:

$$\alpha_3 = \frac{C3}{C3 + C_{sa} + C_{sb}}$$

$$\overline{\alpha_3} = 1 - \alpha_3$$

A calculation manner of the feedback module is as follows:

$$\beta = \frac{C_{sa} - C_{sb}}{C_{sa} + C_{sb}}$$

In an implementation solution, as shown in FIG. 14, the switched-capacitor filter circuit 520 may further include a fourth switch H4 and a fourth capacitor C4. A first end of the fourth switch H4 is connected to the first node Vs; a second end of the fourth switch H4 is connected to a first end of the fourth capacitor C4; and a second end of the fourth capacitor C4 is grounded. Capacitances of the first capacitor C 1, the second capacitor C2, the third capacitor C3, and the fourth capacitor C4 are all different, and a fourth-order filter circuit may be formed by using the first switch H1, the first capacitor C1, the second switch H2, the second capacitor C2, the third switch H3, the third capacitor C3, the fourth switch H4, and the fourth capacitor C4.

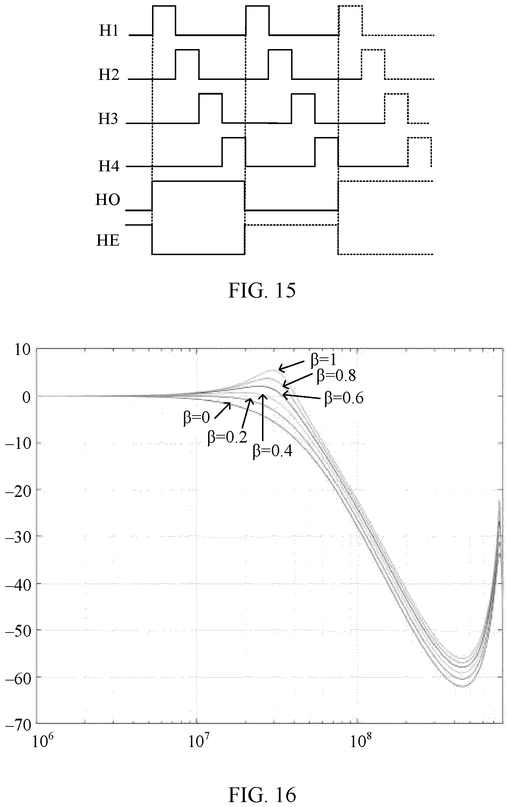

For example, when the discrete-time filter runs, a control time sequence of the discrete-time filter is shown in FIG. 15, where the first switch H1, the second switch H2, the third switch H3, the fourth switch H4, and the switch 530 are controlled through an externally input clock signal. First, a high level may be input to the switch 530, the two ends of the second sampling capacitor Csa are controlled to be respectively connected to the two odd-numbered ends of the switch 530, and a high level is input to the first switch H1 for a period of time, to control the first switch H1 to be turned on. In this case, the first sampling capacitor Csb and the second sampling capacitor Csa may be used for sampling the input signal, and the first capacitor C1 is used for filtering the input signal. After a period of time, a low level is input to the first switch H1, and the first switch H1 is turned off; and a high level is input to the second switch H2, the second switch H2 is controlled to be turned on, and the second capacitor C2 is used for filtering again. After a period of time again, a low level is input to the second switch H2, and the second switch H2 is turned off; and a high level is input to the third switch H3, the third switch H3 is controlled to be turned on, and the third capacitor C3 is used for filtering again. After a period of time again, a low level is input to the third switch H3, and the third switch H3 is turned off; and a high level is input to the fourth switch H4, the fourth switch H4 is controlled to be turned on, and the fourth capacitor C4 is used for filtering again. After a period of time again, a low level is input to the fourth switch H4, the fourth switch H4 is turned off, a low level is input to the switch 530, and the two ends of the second sampling capacitor Csa are controlled to be respectively connected to the two even-numbered ends of the switch 530, to convert the polarities of the two poles of the second sampling capacitor Csa; and a high level is input to the first switch H1, and the first capacitor C1 is used for filtering. After a period of time, a low level is input to the first switch H1, and the first switch H1 is turned off; and a high level is input to the second switch H2, the second switch H2 is controlled to be turned on, and the second capacitor C2 is used for filtering again. After a period of time again, a low level is input to the second switch H2, and the second switch H2 is turned off; a high level is input to the third switch H3, the third switch H3 is controlled to be turned on, and the third capacitor C3 is used for filtering again; after a period of time again, a low level is input to the third switch H3, and the third switch H3 is turned off; and a high level is input to the fourth switch H4, the fourth switch H4 is controlled to be turned on, and the fourth capacitor C4 is used for filtering again. After a period of time again, a low level is input to the fourth switch H4, and the fourth switch H4 is turned off. On this basis, a feedback coefficient of the fourth-order discrete-time filter may be adjusted by changing the polarities of the second sampling capacitor Csa.

Frequency responses of the fourth-order discrete-time filter under different feedback coefficients are shown in FIG. 16.

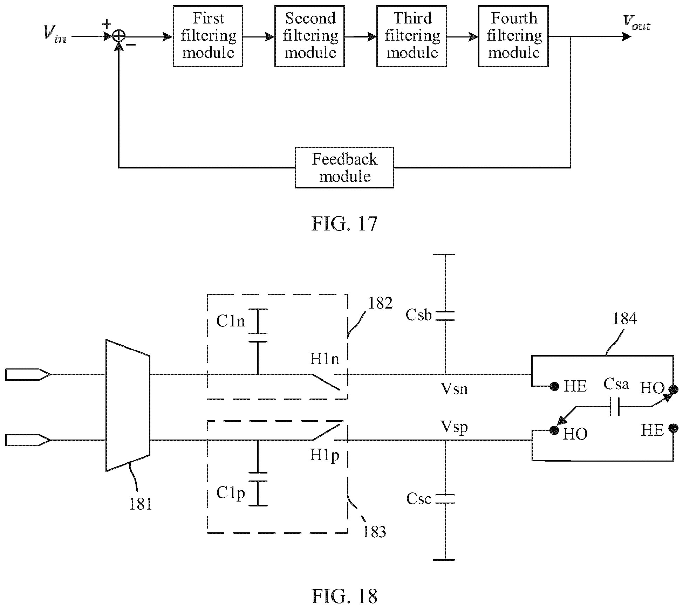

It may be understood that the foregoing discrete-time filter may also be equivalent to a structure shown in FIG. 17. A digital filter formed by a disposed subtractor, first filtering module, second filtering module, third filtering module, fourth filtering module, feedback module, and the like filters an input signal. Specifically, the input signal is sent to the first filtering module through the subtractor; the first filtering module filters an output signal and then sends a filtered signal to the second filtering module; the second filtering module filters the received signal and then sends a filtered signal to the third filtering module; and the third filtering module filters the received signal and then sends a filtered signal to the fourth filtering module for further filtering, to obtain an output signal. In addition, the output signal is also fed back to the subtractor through the feedback module. A function of the first filtering module is:

$$H(z) = \frac{\overline{\alpha_1} z^{-1}}{1 - \alpha_1 z^{-1}}$$

The parameters $\alpha_1$ and $\overline{\alpha_1}$ are calculated as follows:

$$\alpha_1 = \frac{C1}{C1 + C_{sa} + C_{sb}}$$

$$\overline{\alpha_1} = 1 - \alpha_1$$

A function of the second filtering module is:

$$H(z) = \frac{\overline{\alpha_2} z^{-1}}{1 - \alpha_2 z^{-1}}$$

The parameters $\alpha_2$ and $\overline{\alpha_2}$ are calculated as follows:

$$\alpha_2 = \frac{C2}{C2 + C_{sa} + C_{sb}}$$

$$\overline{\alpha_2} = 1 - \alpha_2$$

A function of the third filtering module is:

$$H(z) = \frac{\overline{\alpha_3} z^{-1}}{1 - \alpha_3 z^{-1}}$$

The parameters $\alpha_3$ and $\overline{\alpha_3}$ are calculated as follows:

$$\alpha_3 = \frac{C3}{C3 + C_{sa} + C_{sb}}$$

$$\overline{\alpha_3} = 1 - \alpha_3$$

A function of the fourth filtering module is:

$$H(z) = \frac{\overline{\alpha_4} z^{-1}}{1 - \alpha_4 z^{-1}}$$

The parameters $\alpha_4$ and $\overline{\alpha_4}$ are calculated as follows:

$$\alpha_4 = \frac{C4}{C4 + C_{sa} + C_{sb}}$$

$$\overline{\alpha_4} = 1 - \alpha_4$$

A calculation manner of the feedback module is as follows:

$$\beta = \frac{C_{sa} - C_{sb}}{C_{sa} + C_{sb}}$$

It may be understood that, when the switched-capacitor filter circuit 520 in the discrete-time filter is implemented by using hardware or by using a digital filter, an order may be further increased in the foregoing same manner. Details are not described in embodiments of this application.

In an implementation solution, as shown in FIG. 18, an embodiment of this application further provides another discrete-time filter, including a differential transconductance circuit 181, a first switched-capacitor filter circuit 182, a second switched-capacitor filter circuit 183, a first sampling capacitor Csb, a second sampling capacitor Csa, a third sampling capacitor Csc, and a switch 184. Capacitances of the first sampling capacitor Csb and the third sampling capacitor Csc are the same. A first output end of the differential transconductance circuit 181 is connected to a first node Vsn through the first switched-capacitor filter circuit 182; both a first end of the first sampling capacitor Csb and a first terminal of the switch 184 are connected to the first node Vsn; a second output end of the differential transconductance circuit 181 is connected to a second node Vsp through the second switched-capacitor filter circuit 183; both a first end of the third sampling capacitor Csc and a second terminal of the switch 184 are connected to the second node Vsp; both a second end of the first sampling capacitor Csb and a second end of the third sampling capacitor Csc are grounded; the switch 184 includes two odd-numbered ends and two even-numbered ends, where one odd-numbered end and one even-numbered end are connected to the first terminal of the switch 184, and the other odd-numbered end and the other even-numbered end are connected to the second terminal of the switch 184; and two ends of the second sampling capacitor Csa are respectively connected to the two odd-numbered ends, or two ends of the second sampling capacitor Csa are respectively connected to the two even-numbered ends.

In an implementation solution, the differential transconductance circuit 181 may be a fully-differential transconductance circuit or a semi-differential transconductance circuit of any type. It may be understood that the differential transconductance circuit 181 may also be replaced with the two single-ended transconductance circuits, as shown in FIG. 4a.

For example, a path on which the first switched-capacitor filter circuit 182 connected to the first output end of the differential transconductance circuit 181 is located is an N path, and a path on which the second switched-capacitor filter circuit 183 connected to the second output end of the differential transconductance circuit 181 is located is a P path. Because the second sampling capacitor Csa can adjust the polarities, when the second sampling capacitor Csa is connected to the two odd-numbered ends of the switch 184, the first sampling capacitor Csb, the second sampling capacitor Csa, and the third sampling capacitor Csc may sample an input signal. In this case, there is no feedback. In other words, a feedback coefficient is 0. When the second sampling capacitor Csa is connected to the two even-numbered ends of the switch 184, polarities of two poles of the second sampling capacitor Csa are exchanged, and negative feedback may be respectively provided for the P path and the N path. In this case, because the capacitances of the first sampling capacitor Csb and the third sampling capacitor Csc are the same, a calculation manner of a feedback coefficient β of the P path and the N path is as follows:

$$\beta = \frac{Csa - Csb}{Csa + Csb}$$

$C_{sa}$ represents a capacitance of the second sampling capacitor Csa, and $C_{sb}$ represents the capacitance of the first sampling capacitor Csb. On this basis, the feedback coefficient of the fully-differential circuit inside the discrete-time filter can be adjusted.

In an implementation solution, to adjust the feedback coefficient more flexibly, at least one of the first sampling capacitor Csb, the second sampling capacitor Csa, and the third sampling capacitor Csc may be an adjustable capacitor. The feedback coefficient can be adjusted by adjusting a ratio of the first sampling capacitor Csb to the second sampling capacitor Csa and/or a ratio of the third sampling capacitor Csc to the second sampling capacitor Csa. In an adjustment process, the capacitance of the second sampling capacitor Csa cannot be less than the capacitance of the first sampling capacitor Csb and the capacitance of the third sampling capacitor Csc, and the capacitance of the first sampling capacitor Csb is always the same as the capacitance of the third sampling capacitor Csc.

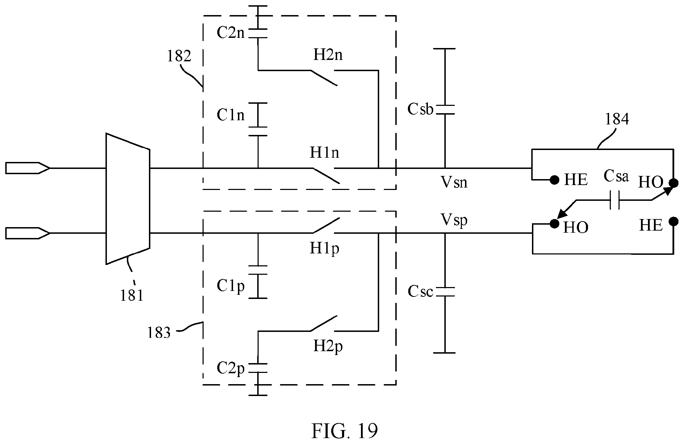

In an implementation solution, as shown in FIG. 19, the first switched-capacitor filter circuit 182 and the second switched-capacitor filter circuit 183 each include a first switch and a first capacitor; both a first end of a first switch H1n and a first end of a first capacitor C1n in the first switched-capacitor filter circuit 182 are connected to the first output end of the differential transconductance circuit 181; a second end of the first switch H1n in the first switched-capacitor filter circuit 182 is connected to the first node Vsn; a second end of the first capacitor C1n in the first switched-capacitor filter circuit 182 is grounded; both a first end of a first switch H1p and a first end of a first capacitor C1p in the second switched-capacitor filter circuit 183 are connected to the second output end of the differential transconductance circuit 181; a second end of the first switch H1p in the second switched-capacitor filter circuit 183 is connected to the second node; and a second end of the first capacitor C1p in the second switched-capacitor filter circuit 183 is grounded. On this basis, the first switched-capacitor filter circuit 182 and the second switched-capacitor filter circuit 183 may be used as a first-order filter circuit.

For example, when a discrete-time filter runs, for a control time sequence of the discrete-time filter, refer to FIG. 7, where the first switches (H1n and H1p) and the switch 184 are controlled through an externally input clock signal. First, a high level may be input to the switch 184, the two ends of the second sampling capacitor Csa are controlled to be respectively connected to the two odd-numbered ends of the switch 184; and high levels are input to the first switches (H1n and H1p), and the first switches (H1n and H1p) are controlled to be turned on. In this case, the first sampling capacitor Csb and the second sampling capacitor Csa may be used for sampling the input signal, and the first capacitor is used for filtering the input signal. After a period of time, the high level of the switch 184 may be switched to a low level, and the two ends of the second sampling capacitor Csa are controlled to be respectively connected to the two even-numbered ends of the switch 184, to convert the polarities of the two poles of the second sampling capacitor Csa. The second sampling capacitor Csa is used for implementing the negative feedback, to adjust the feedback coefficient. On this basis, the feedback coefficient of the first-order fully-differential discrete-time filter can be adjusted.

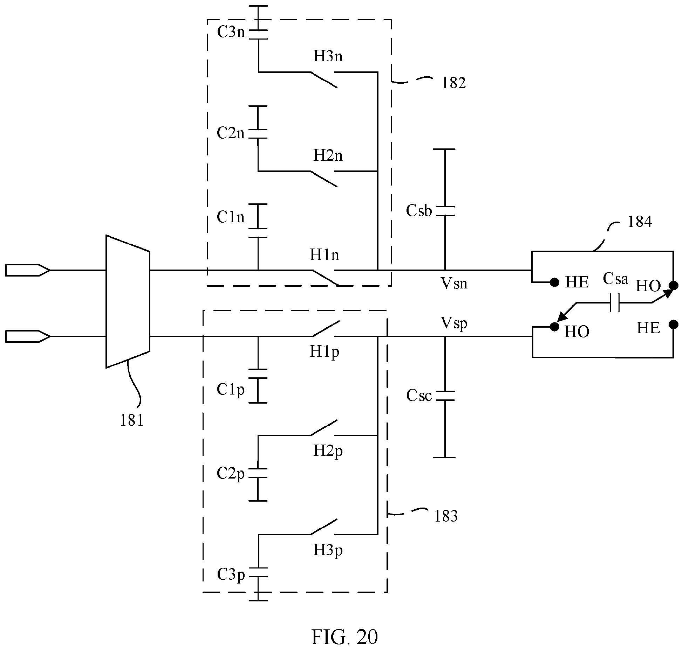

In an implementation solution, as shown in FIG. 20, the first switched-capacitor filter circuit 182 and the second switched-capacitor filter circuit 183 each include a second switch and a second capacitor; a first end of a second switch H2n in the first switched-capacitor filter circuit 182 is connected to the first node Vsn; a second end of the second switch H2n in the first switched-capacitor filter circuit 182 is connected to a first end of a second capacitor C2n in the first switched-capacitor filter circuit 182; a first end of a second switch H2 in the second switched-capacitor filter circuit 183 is connected to the second node Vsp; a second end of the second switch H2p in the second switched-capacitor filter circuit 183 is connected to a first end of a second capacitor C2p in the second switched-capacitor filter circuit 183; and both a second end of the second capacitor C2n in the first switched-capacitor filter circuit 182 and a second end of the second capacitor C2p in the second switched-capacitor filter circuit 183 are grounded. On this basis, the first switched-capacitor filter circuit 182 and the second switched-capacitor filter circuit 183 may be used as a second-order filter circuit.

For example, when a discrete-time filter runs, for a control time sequence of the discrete-time filter, refer to FIG. 9, where the first switches (H1n and H1p), the second switches (H2n and H2p), and the switch 184 are controlled through an externally input clock signal. First, a high level may be input to the switch 184, the two ends of the second sampling capacitor Csa are controlled to be respectively connected to the two odd-numbered ends of the switch 184, and high levels are input to the first switches (H1n and H1p) for a period of time, to control the first switches (H1n and H1p) to be turned on. In this case, the first sampling capacitor Csb and the second sampling capacitor Csa may be used for sampling the input signal, and the first capacitors (C1n and C1p) are used for filtering the input signal. After a period of time, low levels are input to the first switches (H1n and H1p), and the first switches (H1n and H1p) are turned off; and high levels are input to the second switches (H2n and H2p), the second switches (H2n and H2p) are controlled to be turned on, and the second capacitor is used for filtering again. After a period of time, low levels may be input to the second switches (H2n and H2p), and the second switches (H2n and H2p) are turned off; and high levels are input to the first switches (H1n and H1p), a low level is input to the switch 184, and the two ends of the second sampling capacitor Csa are controlled to be respectively connected to the two even-numbered ends of the switch 184, to convert the polarities of the two poles of the second sampling capacitor Csa, and perform filtering by using the first capacitors (C1n and C1p). Then, low levels are input to the first switches (H1n and H1p), and the first switches (H1n and H1p) are turned off; and high levels are input to the second switches (H2n and H2p), the second switches (H2n and H2p) are controlled to be turned on, and the second capacitors (C2n and C2p) are used for filtering again. The negative feedback is implemented by changing the polarities of the second sampling capacitor Csa, to adjust a feedback coefficient of the second-order fully-differential discrete-time filter.

In an implementation solution, the first switched-capacitor filter circuit 182 and the second switched-capacitor filter circuit 183 each include a third switch and a third capacitor; a first end of a third switch H3n in the first switched-capacitor filter circuit 182 is connected to the first node Vsn; a second end of the third switch H3n in the first switched-capacitor filter circuit 182 is connected to a first end of a third capacitor C3n in the first switched-capacitor filter circuit 182; a first end of a third switch H3p in the second switched-capacitor filter circuit 183 is connected to the second node Vsp; a second end of the third switch H3p in the second switched-capacitor filter circuit 183 is connected to a first end of a third capacitor C3p in the second switched-capacitor filter circuit 183; and both a second end of the third capacitor C3n in the first switched-capacitor filter circuit 182 and a second end of the third capacitor C3p in the second switched-capacitor filter circuit 183 are grounded. On this basis, the first switched-capacitor filter circuit 182 and the second switched-capacitor filter circuit 183 may be used as a third-order filter circuit.

For example, when a discrete-time filter runs, for a control time sequence of the discrete-time filter, refer to FIG. 12, where the first switches (H1n and H1p), the second switches (H2n and H2p), the third switch H3, and the switch 184 are controlled through an externally input clock signal. First, a high level may be input to the switch 184, the two ends of the second sampling capacitor are controlled to be respectively connected to the two odd-numbered ends of the switch 184, and high levels are input to the first switches (H1n and H1p) for a period of time, to control the first switches (H1n and H1p) to be turned on. In this case, the first sampling capacitor Csb and the second sampling capacitor may be used for sampling the input signal, and the first capacitors (C1n and C1p) are used for filtering the input signal. After a period of time, low levels are input to the first switches (H1n and H1p), and the first switches (H1n and H1p) are turned off; and high levels are input to the second switches, the second switches (H2n and H2p) are controlled to be turned on, and the second capacitors (C2n and C2p) are used for filtering again. After a period of time again, low levels are input to the second switches (H2n and H2p), and the second switches (H2n and H2p) are turned off; and a high level is input to the third switch H3, the third switch H3 is controlled to be turned on, and the third capacitors (C3n and C3p) are used for filtering again. After a period of time again, a low level is input to the third switch H3, and the third switch H3 is turned off; a low level is input to the switch 184, and the two ends of the second sampling capacitor Csa are controlled to be respectively connected to the two even-numbered ends of the switch 184, to convert the polarities of the two poles of the second sampling capacitor; and high levels are input to the first switches (H1n and H1p), and the first capacitors (C1n and C1p) are used for filtering. After a period of time, low levels are input to the first switches (H1n and H1p), and the first switches (H1n and H1p) are turned off; and a high level is input to the second switch H2, the second switches (H2n and H2p) are controlled to be turned on, and the second capacitors (C2n and C2p) are used for filtering again. After a period of time again, low levels are input to the second switches (H2n and H2p), and the second switches (H2n and H2p) are turned off; and a high level is input to the third switch H3, the third switch H3 is controlled to be turned on, and the third capacitors (C3n and C3p) are used for filtering again. On this basis, a feedback coefficient of the third-order discrete-time filter may be adjusted by changing the polarities of the second sampling capacitor.

It may be understood that the discrete-time filter may also be implemented by using a digital filter. When the first switched-capacitor filter circuit 182 and the second switched-capacitor filter circuit 183 are implemented by using hardware or by using a digital filter, an order may be further increased in the foregoing same manner. Details are not described in embodiments of this application.

In an implementation solution, an embodiment of this application further provides a chip. The chip includes a processor and a memory. The memory stores program instructions for implementing each module in the foregoing digital filter. The processor is configured to execute the program instructions stored in the memory to implement a function of the discrete-time filter.

Further, an embodiment of this application further provides a computer-readable storage medium. The computer-readable storage medium stores program instructions of each module in the foregoing digital filter.

Further, an embodiment of this application further provides a computer program product including instructions. When the computer program product runs on a computer, a function of the digital filter corresponding to the discrete-time filter in this application is implemented.

It should be understood that, the processor mentioned in embodiments of this application may be a central processing unit (central processing unit, CPU), and may further be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, or the processor may be any conventional processor or the like.

It may be further understood that the memory mentioned in embodiments of this application may be a volatile memory or a non-volatile memory, or may include a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

In the several embodiments provided in this application, it should be understood that functional modules in embodiments of this application may be integrated into one processing unit, or each of the units may exist alone physically, or two or more units are integrated into one unit.

When the functions are implemented in a form of a software functional unit and sold or used as an independent product, the functions may be stored in a computer-readable storage medium. Based on such an understanding, the technical solutions in this application essentially, or the part contributing to the conventional technology, or some of the technical solutions may be implemented in a form of a software product. The computer software product is stored in a storage medium and includes several instructions for instructing a computer device (which may be a personal computer, a server, a network device, a terminal device, or the like) to perform all or some of the steps of the methods in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

For related parts of the method embodiments of this application, reference may be made to each other. Terms used in embodiments of this application are merely for the purpose of describing specific embodiments, but are not intended to limit this application. The terms "a" and "the" of singular forms used in embodiments and the appended claims of this application are also intended to include plural forms, unless otherwise specified in the context clearly. It should also be understood that, the term " and/or" used in this specification indicates and includes any or all possible combinations of one or more associated listed items. The character "/" in this specification usually indicates an "or" relationship between the associated objects.

**Claims**

1. A discrete-time filter, comprising a transconductance circuit, a switched-capacitor filter circuit, a first sampling capacitor, a second sampling capacitor, and a switch, wherein
   an output end of the transconductance circuit is connected to a first node through the switched-capacitor filter circuit; both a first end of the first sampling capacitor and a first terminal of the switch are connected to the first node; both a second terminal of the switch and a second end of the first sampling capacitor are grounded; the switch comprises two odd-numbered ends and two even-numbered ends, wherein one odd-numbered end and one even-numbered end are connected to the first terminal of the switch, and the other odd-numbered end and the other even-numbered end are connected to the second terminal of the switch; and two ends of the second sampling capacitor are respectively connected to the two odd-numbered ends, or two ends of the second sampling capacitor are respectively connected to the two even-numbered ends.

2. The discrete-time filter according to claim 1, wherein at least one of the first sampling capacitor and the second sampling capacitor is an adjustable capacitor.

3. The discrete-time filter according to claim 1 or 2, wherein the switched-capacitor filter circuit comprises a first switch and a first capacitor; both a first end of the first switch and a first end of the first capacitor are connected to the output end of the transconductance circuit; a second end of the first switch is connected to the first node; and a second end of the first capacitor is grounded.

4. The discrete-time filter according to claim 3, wherein the switched-capacitor filter circuit further comprises a second switch and a second capacitor; a first end of the second switch is connected to the first node; a second end of the second switch is connected to a first end of the second capacitor; and a second end of the second capacitor is grounded.

5. The discrete-time filter according to claim 4, wherein the switched-capacitor filter circuit further comprises a third switch and a third capacitor; a first end of the third switch is connected to the first node; a second end of the third switch is connected to a first end of the third capacitor; and a second end of the third capacitor is grounded.

6. A discrete-time filter, comprising a differential transconductance circuit, a first switched-capacitor filter circuit, a second switched-capacitor filter circuit, a first sampling capacitor, a second sampling capacitor, a third sampling capacitor, and a switch, wherein

a first output end of the differential transconductance circuit is connected to a first node through the first switched-capacitor filter circuit; and both a first end of the first sampling capacitor and a first terminal of the switch are connected to the first node;

a second output end of the differential transconductance circuit is connected to a second node through the second switched-capacitor filter circuit; both a first end of the third sampling capacitor and a second terminal of the switch are connected to the second node; and both a second end of the first sampling capacitor and a second end of the third sampling capacitor are grounded; and

the switch comprises two odd-numbered ends and two even-numbered ends, wherein one odd-numbered end and one even-numbered end are connected to the first terminal of the switch, and the other odd-numbered end and the other even-numbered end are connected to the second terminal of the switch; and two ends of the second sampling capacitor are respectively connected to the two odd-numbered ends, or two ends of the second sampling capacitor are respectively connected to the two even-numbered ends.

7. The discrete-time filter according to claim 6, wherein at least one of the first sampling capacitor, the second sampling capacitor, and the third sampling capacitor is an adjustable capacitor.

8. The discrete-time filter according to claim 6 or 7, wherein the first switched-capacitor filter circuit and the second switched-capacitor filter circuit each comprise a first switch and a first capacitor; both a first end of the first switch and a first end of the first capacitor in the first switched-capacitor filter circuit are connected to the first output end of the differential transconductance circuit; a second end of the first switch in the first switched-capacitor filter circuit is connected to the first node; a second end of the first capacitor in the first switched-capacitor filter circuit is grounded; both a first end of the first switch and a first end of the first capacitor in the second switched-capacitor filter circuit are connected to the second output end of the differential transconductance circuit; a second end of the first switch in the second switched-capacitor filter circuit is connected to the second node; and a second end of the first capacitor in the second switched-capacitor filter circuit is grounded.

9. The discrete-time filter according to claim 8, wherein the first switched-capacitor filter circuit and the second switched-capacitor filter circuit each comprise a second switch and a second capacitor; a first end of the second switch in the first switched-capacitor filter circuit is connected to the first node; a second end of the second switch in the first switched-capacitor filter circuit is connected to a first end of the second capacitor in the first switched-capacitor filter circuit; a first end of the second switch in the second switched-capacitor filter circuit is connected to the second node; a second end of the second switch in the second switched-capacitor filter circuit is connected to a first end of the second capacitor in the second switched-capacitor filter circuit; and both a second end of the second capacitor in the first switched-capacitor filter circuit and a second end of the second capacitor in the second switched-capacitor filter circuit are grounded.

10. The discrete-time filter according to claim 9, wherein the first switched-capacitor filter circuit and the second switched-capacitor filter circuit each comprise a third switch and a third capacitor; a first end of the third switch in the first switched-capacitor filter circuit is connected to the first node; a second end of the third switch in the first switched-capacitor filter circuit is connected to a first end of the third capacitor in the first switched-capacitor filter circuit; a first end of the third switch in the second switched-capacitor filter circuit is connected to the second node; a second end of the third switch in the second switched-capacitor filter circuit is connected to a first end of the third capacitor in the second switched-capacitor filter circuit; and both a second end of the third capacitor in the first switched-capacitor filter circuit and a second end of the third capacitor in the second switched-capacitor filter circuit are grounded.

11. A receiver, comprising a mixer, a filter, and an analog-to-digital converter that are sequentially connected, wherein the filter comprises the discrete-time filter according to any one of claims 1 to 10.

12. A transmitter, comprising a digital-to-analog converter, a filter, and a mixer that are sequentially connected, wherein the filter comprises the discrete-time filter according to any one of claims 1 to 10.

13. A communication device, comprising the receiver according to claim 11 and a receive antenna connected to the receiver, and/or the transmitter according to claim 12 and a transmit antenna connected to the transmitter.

FIG. 1a

FIG. 1b

FIG. 2a

FIG. 2b

FIG. 3

FIG. 4a

FIG. 4b

FIG. 5

FIG. 6

FIG. 7

FIG. 8

FIG. 9

FIG. 10

FIG. 11

FIG. 12

FIG. 13

FIG. 14

FIG. 15

FIG. 16

$V_{in}$ → + ⊕ − → First filtering module → Second filtering module → Third filtering module → Fourth filtering module → $V_{out}$

Feedback module

FIG. 17

FIG. 18

FIG. 19

FIG. 20

| | **INTERNATIONAL SEARCH REPORT** | | International application No.<br>**PCT/CN2023/101064** |
|---|---|---|---|

| A. | CLASSIFICATION OF SUBJECT MATTER |
|---|---|
| | H03H7/01(2006.01)i |

According to International Patent Classification (IPC) or to both national classification and IPC

| B. | FIELDS SEARCHED |
|---|---|

Minimum documentation searched (classification system followed by classification symbols)

H03H

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: 离散时间滤波器, 采样, 电容, 负反馈, 极性反转, 开关, 跨导, 奇数端, 偶数端, filter, switch, capacitor, negative feedback, transconductance

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 101873058 A (SONY CORP.) 27 October 2010 (2010-10-27)<br>entire document | 1-13 |
| A | KR 20050100363 A (NOKIA CORP.) 18 October 2005 (2005-10-18)<br>entire document | 1-13 |
| A | CN 109690947 A (QUALINX B. V.) 26 April 2019 (2019-04-26)<br>entire document | 1-13 |
| A | US 2010156561 A1 (SONY CORP.) 24 June 2010 (2010-06-24)<br>entire document | 1-13 |
| A | WO 2013189547 A1 (HUAWEI TECHNOLOGIES CO., LTD.) 27 December 2013<br>(2013-12-27)<br>entire document | 1-13 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| **08 September 2023** | **11 September 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/101064**

| Patent document cited in search report | | | Publication date (day/month/year) | Patent family member(s) | | | Publication date (day/month/year) |
|---|---|---|---|---|---|---|---|
| CN | 101873058 | A | 27 October 2010 | US | 2010264751 | A1 | 21 October 2010 |
| | | | | US | 8633617 | B2 | 21 January 2014 |
| | | | | JP | 2010258528 | A | 11 November 2010 |
| | | | | CN | 101873058 | B | 09 July 2014 |
| KR | 20050100363 | A | 18 October 2005 | KR | 100711824 | B1 | 30 April 2007 |
| CN | 109690947 | A | 26 April 2019 | JP | 2019523603 | A | 22 August 2019 |
| | | | | JP | 6960447 | B2 | 05 November 2021 |
| | | | | US | 2019140610 | A1 | 09 May 2019 |
| | | | | US | 10749503 | B2 | 18 August 2020 |
| | | | | WO | 2018009059 | A1 | 11 January 2018 |
| | | | | NL | 2017551 | B1 | 10 January 2018 |
| | | | | EP | 3479478 | A1 | 08 May 2019 |
| | | | | EP | 3479478 | B1 | 13 May 2020 |
| | | | | CA | 3029789 | A1 | 11 January 2018 |
| | | | | CA | 3029789 | C | 13 April 2021 |
| | | | | CN | 109690947 | B | 23 June 2023 |
| US | 2010156561 | A1 | 24 June 2010 | US | 8279023 | B2 | 02 October 2012 |
| | | | | JP | 2010148044 | A | 01 July 2010 |
| WO | 2013189547 | A1 | 27 December 2013 | US | 2014194081 | A1 | 10 July 2014 |
| | | | | CN | 103828244 | A | 28 May 2014 |
| | | | | CN | 103828244 | B | 02 March 2016 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210736778

- CN 202211091909